(19) Europäisches Patentamt

European Patent Office

Office européen des brevets

(11) Veröffentlichungsnummer: **0 249 837 B1**

(12) **EUROPÄISCHE PATENTSCHRIFT**

(45) Veröffentlichungstag der Patentschrift: **18.12.91**

(51) Int. Cl.⁵: **H04Q 3/52**, H03K 5/02

(21) Anmeldenummer: **87108206.1**

(22) Anmeldetag: **05.06.87**

(54) **Breitbandsignal-Koppeleinrichtung.**

(30) Priorität: **19.06.86 DE 3620468**

(43) Veröffentlichungstag der Anmeldung:
**23.12.87 Patentblatt 87/52**

(45) Bekanntmachung des Hinweises auf die
Patenterteilung:
**18.12.91 Patentblatt 91/51**

(84) Benannte Vertragsstaaten:
**AT BE CH DE FR GB IT LI NL SE**

(56) Entgegenhaltungen:
**EP-A- 0 088 291**
**EP-A- 0 142 167**
**FR-A- 2 192 416**
**FR-A- 2 365 263**
**US-A- 4 434 381**

(73) Patentinhaber: **SIEMENS AKTIENGESELL-
SCHAFT**
**Wittelsbacherplatz 2**
**W-8000 München 2(DE)**

(72) Erfinder: **Trumpp, Gerhard**
**Mitterlängstrasse 7**
**W-8039 Puchheim(DE)**
Erfinder: **König, Wilhelm**
**Theresienstrasse 48**
**W-8000 München 2(DE)**
Erfinder: **Lang, Thomas**
**Schlesierstrasse 3**
**W-8028 Taufkirchen(DE)**

## Beschreibung

Neuere Entwicklungen der Fernmeldetechnik führen zu diensteintegrierenden Nachrichtenübertragungs- u. - vermittlungssystemen für Schmalband- und Breitband-Kommunikationsdienste, die als Übertragungsmedium im Bereich der Teilnehmeranschlußleitungen Lichtwellenleiter vorsehen, über die sowohl die Schmalbandkommunikationsdienste, wie insbesondere 64-kbit/s-Digital-Telefonie, als auch Breitbandkommunikationsdienste, wie insbesondere 140-Mbit/s-Bildtelefonie, geführt werden, wobei aber in den Vermittlungsstellen (vorzugsweise gemeinsame Steuereinrichtungen aufweisende) Schmalbandsignal-Koppeleinrichtungen und Breitbandsignal-Koppeleinrichtungen nebeneinander vorgesehen sind (DE-PS 24 21 002).

Im Zusammenhang mit einer Breitbandsignal-Zeitmultiplex-Koppeleinrichtung, deren Koppelpunkte im Zeitmultiplex jeweils für eine Mehrzahl von Verbindungen genutzt werden, ist es bekannt, jeweils zwei Leitungen mit Hilfe eines Gatterelements zu verbinden, das von einer als bistabiles D-Kippglied gebildeten koppelpunktindividuellen Speicherzelle ein- und ausgeschaltet wird, wobei diese koppelpunktindividuelle Speicherzelle, deren Clock-Eingang ein entsprechendes Taktsignal zugeführt wird, in nur einer Koordinatenrichtung, und zwar an ihrem D-Eingang, angesteuert wird (Pfannschmidt: "Arbeitsgeschwindigkeitsgrenzen von Koppelnetzwerken für Breitband-Digitalsignale", Diss., Braunschweig 1978, Bild 6.7, ferner Bild 6.4). In Anbetracht eines bei einer Bitrate von 140 Mbit/s erreichbaren Zeitmultiplexfaktors von etwa 4 bis 8 und der dabei erforderlichen aufwendigen Schaltungstechnologie werden derzeit allerdings zur Vermittlung von Breitbandsignalen reine Raumkoppeleinrichtungen bevorzugt, in denen die über die einzelnen Koppelpunkte durchgeschalteten Verbindungen allein räumlich voneinander getrennt sind.

Eine reine Breitbandsignal-Raumkoppelanordnung kann als mit Eingangsverstärkern und Ausgangsverstärkern versehene Koppelpunktmatrix in C-MOS-Technik ausgebildet sein, in deren Koppelpunkten die Koppelelemente jeweils von einer decodergesteuerten, koppelpunktindividuellen Halte-Speicherzelle gesteuert werden, wobei die Koppelelemente jeweils als C-MOS-Transfergate (C-MOS-Transmissionsgate) ausgebildet sind (ISS'84 Conference Papers 23C1, Fig.9); die koppelpunktindividuellen Halte-Speicherzellen eines reinen Raumkoppelvielfachs können von einem Zeilendecoder und von einem Spaltendecoder her jeweils über eine zeilen-bzw. spaltenindividuelle Ansteuerleitung in zwei Koordinaten angesteuert werden (Pfannschmidt, a.a.O., Bild 6.4). In einer Koppelmatrix vorgesehene Ausgangsverstärker können auch in Abhängigkeit von der Aktivierung (mindestens) eines Koppelpunkts der zugehörigen Matrixleitung aktiviert sein (FR-A-2 365 263, FIG.5).

Es ist weiter (aus Electronics, Dec.15, 1983, p.88/89) in allgemeiner Form bekannt, in einer Breitbandsignal-Koppelpunktmatrix digitale Koppelpunkte in Form von Tristate-Invertern vorzusehen, deren konkrete Realisierung dabei indessen offenbleibt, jedenfalls aber eine Mehrzahl von Transistoren erfordert.

Einen besonders geringen Transistoraufwand bei der konkreten Realisierung der einzelnen Koppelpunkte weist eine (in DE-P 36 04 605.1 (VPA 86P1060) beschriebene) Breitbandsignal-Raumkoppeleinrichtung mit einer Koppelpunktmatrix in FET-Technik, deren Koppelelemente jeweils von einer decodergesteuerten, koppelpunktindividuellen Speicherzelle gesteuert werden, auf, bei der die Koppelelemente jeweils durch einen einzigen, von der Speicherzelle an seiner Gate-Elektrode mit einem den oberen (Grenz-)Wert eines durchzuschaltenden Signals um mehr als die Transistor-Pinch-Off-Spannung überschreitenden Durchschaltepotential bzw. mit einem den durch Erhöhung des unteren (Grenz-)Werts eines durchzuschaltenden Signals um die Transistor-Pinch-Off-Spannung sich ergebenden Pegel unterschreitenden Sperrpotential beaufschlagten n-Kanal-Transistor gebildet sind.

Man kann so in einer Koppelpunktmatrix vorgesehene, in einfacher Weise jeweils durch eine koppelpunktindividuelle Halte-Speicherzelle gesteuerte Koppelelemente mit minimalem Transistoraufwand, ohne Inverter und ohne einen in einem C-MOS-Transfergate vorzusehenden, wegen seines höheren spezifischen Widerstands eine grössere Fläche erfordernden p-Kanal-Transistor und damit - was bei einer Integration von besonderer Bedeutung ist - mit entsprechend geringem Platzbedarf und mit entsprechend geringen Schaltungskapazitäten realisieren.

Eine zusätzliche Reduzierung der Schaltungsgröße und damit des Platzbedarfs eines solchen Koppelpunktes ergibt sich mit einer durch zwei Ansteuerdecoder (Zeilendecoder, Spaltendecoder) in zwei Koordinaten angesteuerten, koppelpunktindividuellen Speicherzelle, die durch einen n-Kanal-Transistor und zwei kreuzgekoppelte Inverterschaltungen gebildet ist, deren eine eingangsseitig mit dem zugehörigen Decoderausgang des einen Ansteuerdecoders über den n-Kanal-Transistor verbunden ist, der seinerseits an seiner Steuerelektrode mit dem Ausgangssignal des zugehörigen Decoderausgangs des anderen Ansteuerdecoders beaufschlagt ist, und deren andere ausgangsseitig zum Steuereingang des zugehörigen Koppelelements führt.

Über eine solche vorgeschlagene Breitbandsignal-Raumkoppeleinrichtung mit einer beispielsweise 64 Eingänge und 32 Ausgänge aufweisenden Koppelpunktmatrix in FET-Technik lassen sich beliebig asynchrone Signale mit Bitraten bis in der Größenordnung von 170 Mbit/s und damit insbesondere auch ein einen sog. H4-Kanal ausfüllendes (etwa 140-Mbit/s-)Signal jeweils zwischen einem Eingang und einem Ausgang (oder - bei Verteildiensten - auch mehreren Ausgängen) durchschalten. Es erhebt sich indessen die Forderung, nicht nur jeweils einen ganzen H4-Kanal vermitteln zu können, sondern auch Unterkanäle, beispielsweise sog. H3-Kanäle für (etwa) 34-Mbit/s-Signale. Eine solche Unterkanalvermittlung läßt sich prinzipiell mit Hilfe von den jeweiligen (H4-)Kanal in seine (H3-)Unterkanäle zerlegenden Demultiplexern vor der Koppeleinrichtung und die Unterkanäle wieder zu einem Kanal zusammenfassenden Multiplexern hinter der Koppeleinrichtung erreichen, wobei die Koppeleinrichtung selbst die einzelnen Unterkanäle jeweils für sich vermittelt; dies setzt allerdings eine entsprechende Vervielfachung der Eingänge und Ausgänge der Koppelpunktmatrix voraus, die statt im Beispiel zunächst 64 x 32 Koppelpunkten dann beispielsweise 256 x 128 Koppelpunkte aufweisen muß. Dabei bringt die Forderung nach voller Verteildienstfähigkeit der Koppelpunktmatrix das Problem mit sich, daß jeder der (im Beispiel 256) Eingänge einer solchen Koppelpunktmatrix durch alle (im Beispiel 128) Ausgänge der Koppelpunktmatrix gleichzeitig belastbar sein muß. Dies würde an sich 256 übermäßig große Eingangstreiberschaltungen erfordern, deren Querströme und Verlustleistung indessen die Machbarkeit eines solchen Koppelpunktmatrix-Bausteins erheblich erschweren würden.

Die Erfindung stellt sich demgegenüber die Aufgabe, eine Breitbandsignal-Koppeleinrichtung anzugeben, die den im vorstehenden umrissenen Anforderungen ohne solche Erschwernisse gerecht zu werden vermag.

Die Erfindung betrifft eine Breitbandsignal-Koppeleinrichtung mit einer Koppelpunktmatrix in FET-Technik, an deren Eingängen jeweils eine Eingangstreiberschaltung vorgesehen sein kann und deren Ausgänge jeweils mit einer Ausgangsverstärkerschaltung versehen sind; diese Breitbandsignal-Koppeleinrichtung ist erfindungsgemäß dadurch gekennzeichnet, daß die Koppelpunkte mit im Durchschaltezustand jeweils einen gegenüber dem an einem Matrixeingang wirksamen Innenwiderstand großen Durchlass- bzw. Innenwiderstand aufweisenden Koppelelementen gebildet sind und daß die Ausgangsverstärkerschaltungen jeweils eine in die betreffende Ausgangsleitung eingefügte Kettenschaltung wenigstens eines invertierenden C-MOS-Verknüpfungsgliedes, vorzugsweise eines C-MOS-Inverters, und eines Haltegliedes, vorzugsweise eines D-Kippgliedes, und einen mit seiner einen Hauptelektrode am Verknüpfungsglied-Eingang liegenden Schalter mit gegenüber dem Widerstand eines Koppelelements kleinem Durchlaßwiderstand aufweisen, dessen Steuerelektrode - ggf. zusammen mit dem Takteingang des D-Kippgliedes - mit einem eine Bit-Durchschaltezeitspanne in eine Vorphase und eine die eigentliche Durchschaltephase (ph) unterteilenden Koppelfeld-Durchschalte-Takt beaufschlagt ist und über den in jeder Vorphase die betreffende Ausgangsleitung der Koppelpunktmatrix zumindest angenähert auf das der Schaltschwelle des Verknüpfungsgliedes entsprechende Potential umgeladen wird, um hiervon ausgehend in der nachfolgenden Durchschaltephase über das jeweilige Koppelelement auf das dem damit jeweils durchgeschalteten Bit entsprechende Potential umgeladen zu werden.

Es sei an dieser Stelle bemerkt, daß (z. B. aus US-A-4 434 381) nach dem soq. Auto-Zero-Prinzip arbeitende Abtast-Verstärker (Sense Amplifier) an sich bekannt sind.

Probleme einer besonders zweckmäßigen Ausbildung einer Breitbandsignal-Koppeleinrichtung werden dabei nicht berührt; hierzu zeigt aber die Erfindung einen Weg.

Die Erfindung, die sich den Umstand zunutze macht, daß ein C-MOS-Verknüpfungsglied in der Umgebung seiner Schaltschwelle eine hohe Spannungsverstärkung aufweist, bringt den Vorteil mit sich, daß schon ein - noch keine übermäßigen Anforderungen an die Eingangstreiberschaltungen und ihre Querströme und Verlustleistungen stellender - kleiner Signalhub und eine dadurch bewirkte kleine Umladung der jeweils zum Verknüpfungsgliedeingang führenden Ausgangsleitungsabschnitte ausreicht, um am jeweiligen Verknüpfungsgliedausgang und damit auf dem von dort weiterführenden Ausgangsleitungsabschnitt einen eindeutigen Übergang des Digitalsignals vom jeweils einen in den jeweils anderen Signalzustand zu bewirken.

Dabei kann in weiterer Ausgestaltung der Erfindung die andere Hauptelektrode des Schalters am Ausgang des Verknüpfungsgliedes liegen; alternativ dazu ist es aber auch möglich, daß die andere Hauptelektrode des Schalters am Ausgang eines besonderen Referenzspannungsgenerators liegt, der in weiterer Ausgestaltung der Erfindung mit einem in gleicher Weise wie ein Inverter, mit dem das Verknüpfungsglied der genannten Kettenschaltung gebildet ist, dimensionierten, rückgekoppelten C-MOS-Inverter gebildet sein kann und der ggf. auch einer Mehrzahl von Schaltern als gemeinsamer Referenzspannungsgenerator dienen kann.

Weitere Besonderheiten der Erfindung werden aus der nachfolgenden näheren Erläuterung der Erfindung anhand der Zeichnungen ersichtlich. Dabei zeigen

FIG 1 und FIG 2

das Schema einer Breitband-Koppeleinrichtung mit ihren Koppelpunkten und

FIG 3 und FIG 4

Einzelheiten ihrer schaltungstechnischen Realisierung gemäß der Erfindung;

FIG 5

verdeutlicht Signalverläufe darin.

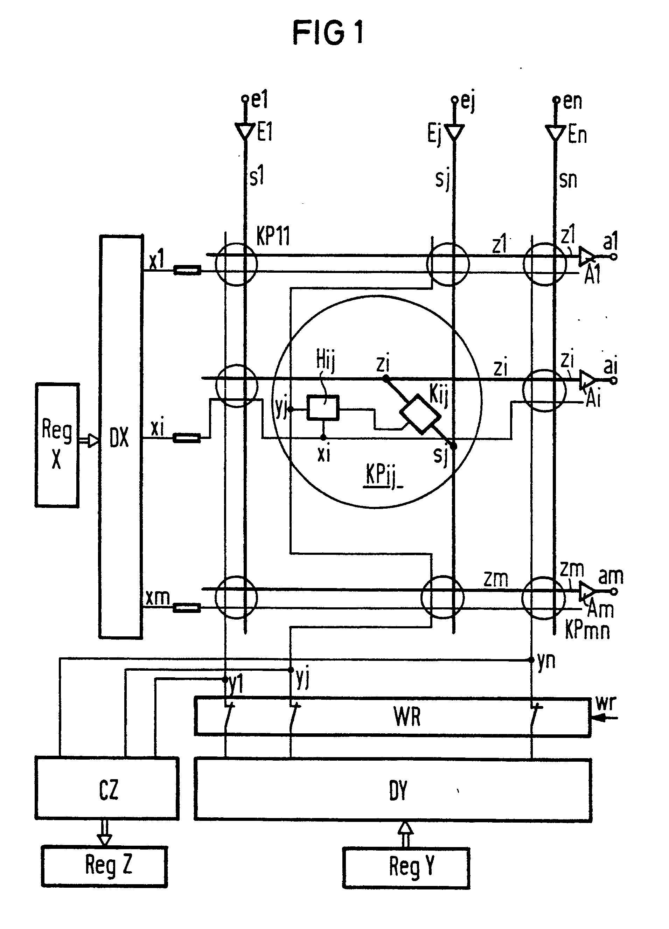

In der Zeichnung FIG 1 ist schematisch in zum Verständnis der Erfindung erforderlichem Umfange eine Breitbandsignal-Koppeleinrichtung skizziert, an deren zu Spaltenleitungen sl...sj...sn einer Koppelpunktmatrix führenden Eingängen el...ej...en Eingangstreiberschaltungen El...Ej...En vorgesehen sind und deren von Zeilenleitungen zl...zi...zm der Koppelpunktmatrix erreichte Ausgänge al...ai...am mit Ausgangsverstärkerschaltungen Al...Ai...Am versehen sind. Die Koppelpunktmatrix weist Koppelpunkte KPll...KPij...KPmn auf, deren Koppelelemente, wie dies beim Koppelpunkt KPij für dessen Koppelelement Kij weiter ins Einzelne gehend angedeutet ist, jeweils von einer koppelpunktindividuellen Halte-Speicherzelle Hij (beim Koppelpunkt KPij) gesteuert werden, deren Ausgang zum Steuereingang des jeweiligen Koppelelements (Kij beim Koppelpunkt KPij) führt.

Die Halte-Speicherzellen ... Hij... werden gemäß FIG 1 durch zwei Ansteuerdecoder, nämlich einen Zeilendecoder DX und einen Spaltendecoder DY, über entsprechende Ansteuerleitungen xl...xi...xm; yl...yj...yn in zwei Koordinaten angesteuert.

Dazu mögen, wie dies aus FIG 1 ersichtlich ist, die beiden Ansteuerdecoder DX, DY von Eingangsregistern Reg X, Reg Y jeweils mit einer einer Matrixreihe (Zeile bzw.Spalte) von Koppelpunkten gemeinsamen Koppelpunktzeilen- bzw. Koppelpunktspalten-Adresse beaufschlagbar sein, auf die hin sie jeweils an der der jeweiligen Koppelpunktreihen-Adresse entsprechenden Ansteuerleitung jeweils ein "1"-Ansteuersignal abgeben. Das Zusammentreffen eines Zeilenansteuersignals "1" und eines Spaltenansteuersignals "1" am Kreuzungspunkt der betreffenden Matrixzeile mit der betreffenden Matrixspalte beim Aufbau einer entsprechenden Verbindung bewirkt dann eine Aktivierung der dort befindlichen Halte-Speicherzelle, beispielsweise der Halte-Speicherzelle Hij, mit der Folge, daß das von der betreffenden Halte-Speicherzelle (Hij) gesteuerte Koppelelement, im Beispiel das Koppelelement Kij, leitend wird.

Damit das im Beispiel betrachtete Koppelelement Kij beim Abbau der betreffenden Verbindung wieder gesperrt wird, wird wiederum der Ansteuerdecoder DX vom Eingangsregister Reg X mit der betreffenden Zeilenadresse beaufschlagt, so daß der Zeilendecoder DX wiederum auf seiner Ausgangsleitung xi ein Zeilenansteuersignal "1" abgibt, und zugleich wird der Spaltendecoder DY von seinem Eingangsregister Reg Y her beispielsweise mit einer Leeradresse oder mit der Adresse einer Spalte von unbeschalteten Koppelpunkten beaufschlagt, so daß er auf seiner Ausgangsleitung yj ein Spaltenansteuersignal "0" abgibt; das Zusammentreffen von Zeilenansteuersignal "1" und Spaltenansteuersignal "0" bewirkt dann die Rücksetzung der Halte-Speicherzelle Hij mit der Folge, daß das von ihr gesteuerte Koppelelement Kij gesperrt wird.

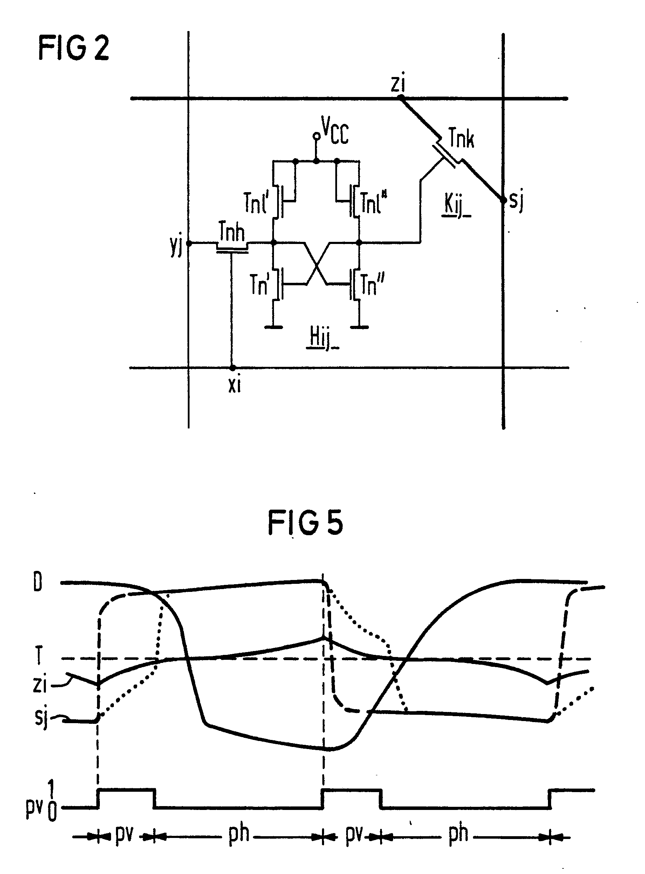

Wie dies aus FIG 2 ersichtlich wird, kann die durch die beiden Ansteuerdecoder (Zeilendecoder DX und Spaltendecoder DY in FIG 1) in zwei Koordinaten angesteuerte Speicherzelle Hij durch einen n-Kanal-Transistor Tnh und zwei kreuzgekoppelte Inverterschaltungen Tn',Tnl'; Tn'',Tnl'' gebildet sein, deren eine (Tn',Tnl') eingangsseitig mit dem zugehörigen Decoderausgang yj des einen Ansteuerdecoders (DY in FIG 1) über den n-Kanal-Transistor Tnh verbunden ist, der seinerseits an seiner Steuerelektrode mit dem Ausgangssignal des zugehörigen Decoderausgangs xi des anderen Ansteuerdecoders (DX in FIG 1) beaufschlagt ist, während die andere der beiden kreuzgekoppelten Inverterschaltungen ausgangsseitig zum Steuereingang des zugehörigen Koppelelements Kij führt.

Das Koppelelement Kij kann beispielsweise mit einem Tristate-Treiber oder, wie dies auch FIG 2 zeigt, durch einen einzigen n-Kanal-Transistor Tnk gebildet sein, der an seiner Gate-Elektrode mit einem den oberen (Grenz-)Wert eines zwischen Spaltenleitung (Eingangsleitung) sj und Zeilenleitung (Ausgangsleitung) zi durchzuschaltenden Signals um mehr als die Transistor-Pinch-Off-Spannung überschreitenden Durchschaltepotential ("H"-Pegel) bzw. mit einem den durch Erhöhung des unteren (Grenz-)Werts eines zwischen Spaltenleitung (Eingangsleitung) sj und Zeilenleitung (Ausgangsleitung) zi durchzuschaltenden Signals um die Transistor-Pinch-Off-Spannung gegebenen Pegel unterschreitenden Sperrpotential ("L"-Pegel) beaufschlagt wird. Solche Realisierungen von Haltespeicherzelle Hij und Koppelelement Kij werden bereits an anderer Stelle (DE-P 36 04 605.1) beschrieben, so daß weitere Erläuterungen hier nicht erforderlich sind. Wesentlich ist hier lediglich, daß der Durchlaßwiderstand eines solchen Koppelelements groß gegenüber dem an der Matrix-Spaltenleitung sj wirksamen Innenwiderstand der dort vorgesehenen Eingangstreiberschaltung Ej (in FIG 1) ist, was durch eine entsprechende Auslegung der Transistorgeometrie leicht zu verwirklichen ist.

In FIG 1 ist noch angedeutet, daß den Ausgängen des Spaltendecoders DY Schreibschalter WR nachgeschaltet sind, die nur bei Auftreten eines Schreibbefehls auf einer Freigabeleitung wr geschlossen sein mögen und dann das ggf. an einem Decoderausgang auftretende "1"-Ansteuersignal ("L") und den an die übrigen Decoderausgängen auftretenden "0"-Ansteuersignale ("H") niederohmig auf die einzelnen Spaltenansteuerleitungen yl,...,yj,...,yn durchschalten, so daß in der zuvor erläuterten Weise die jeweils angesteuerten Koppelelemente in den Durchschalte- bzw. Sperrzustand gelangen.

Soll dagegen der Koppelzustand einer Zeile von Koppelpunkten der Koppelpunktmatrix lediglich ausgelesen werden, wozu die betreffende Zeilenansteuerleitung, beispielsweise die Leitung xi, wiederum, wie bei einem Verbindungsaufbau oder Verbindungsabbau, mit einem "1"-Ansteuersignal ("H") beaufschlagt wird, so bleiben die Schreibschalter WR infolge Ausbleibens eines auf der Freigabeleitung wr auftretenden Schreibbefehls geöffnet mit der Folge, daß die Spaltenansteuerleitungen yl,...,yj,..,yn vom Spaltendecoder DY her jetzt kein Steuerpotential erhalten. Über die erwähnten, durch das Zeilenansteuersignal "H" von ihrer Gate-Elektrode her dennoch entriegelten n-Kanal-Transistoren Tnh (in FIG 2) der Halte-Speicherzellen Hij der betreffenden Koppelpunktzeile ...Kpij... kann dann ein in der Halte-Speicherzelle Hij gerade herrschender Signalzustand auf die jeweilige Spaltenansteuerleitung (yj in FIG 2) durchgeschaltet werden, wobei bei fehlerfreiem Betrieb auf nicht mehr als einer Spaltenansteuerleitung yl,...,yj,...,yn (in FIG 1) ein "L"-Potential auftreten darf. Wie dies auch in FIG 1 angedeutet ist, kann die Adresse dieser Spaltenansteuerleitung und damit die Adresse des betreffenden Koppelpunktes mit Hilfe eines Coders CZ gewonnen und von diesem auf ein folgendes Register Reg Z weitergegeben werden.

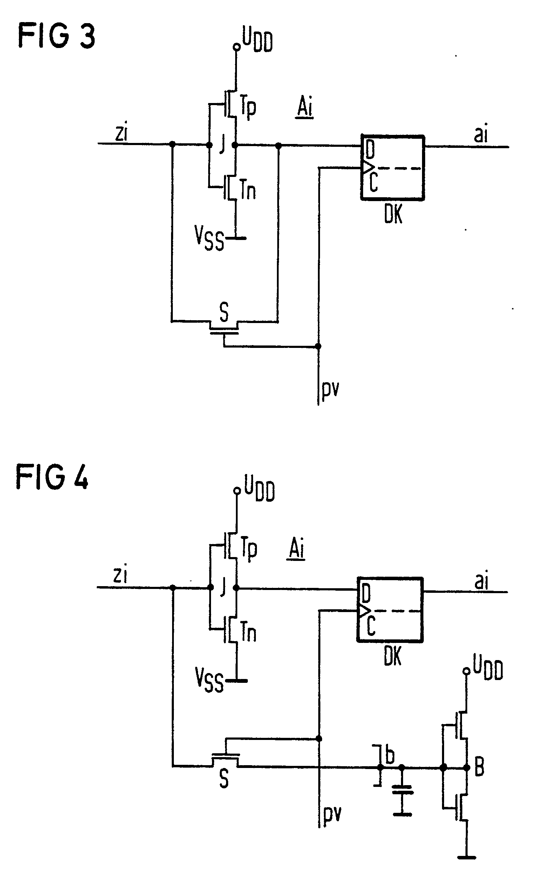

Die zwischen einer Zeilenleitung zi (in FIG 1 und FIG 2) und dem nachfolgenden Ausgang ai (in FIG 1) der Koppelpunktmatrix vorgesehene Ausgangsverstärkerschaltung Ai (in FIG 1) weist nun, wie dies auch FIG 2 und FIG 4 verdeutlichen, eine zwischen die betreffenden Ausgangsleitungsabschnitte zi und ai eingefügte Kettenschaltung eines mit zwei MOS-Transistoren Tp, Tn gebildeten C-MOS-Inverters J und eines flankengesteuerten D-Kippgliedes DK sowie einen mit einem weiteren MOS-Transistor S gebildeten Schalter auf, dessen Durchlasswiderstand klein gegenüber dem Durchlasswiderstand eines Koppelelements Kij (in FIG 1 und FIG 2) ist. Mit seiner einen Hauptelektrode liegt der Schalter-Transistor S am Eingang zi des Inverters J; seine Steuerelektrode liegt zusammen mit dem Takteingang C des D-Kippgliedes DK an einer Taktleitung pv, die mit einem eine Bit-Durchschaltezeitspanne in in FIG 5 unten angedeuteter Weise in eine Vorphase pv und eine Hauptphase ph unterteilenden Takt pv beaufschlagt sein möge, wie er ebenfalls in FIG 5 unten angedeutet ist.

In der in FIG 3 dargestellten Ausgangsverstärkerschaltung Ai liegt die andere Hauptelektrode des Schalter-Transistors S am Ausgang des Inverters J und damit am Eingang D des D-Kippgliedes DK. Während der Vorphase pv (siehe FIG 5 unten) ist der den Ausgang (D) des Inverters J mit dessen Eingang verbindende Schalter-Transistor S leitend, sodaß die zum Invertereingang führende Matrix-Zeilenleitung zi auf ein der Schaltschwelle des Inverters J entsprechendes Potential geladen wird. Hiervon ausgehend wird dann in der nachfolgenden Hauptphase ph (siehe FIG 5 unten), in welcher der Schalter-Transistor S gesperrt ist, von der zugehörigen Spaltenleitung sj (in FIG 1 und FIG 2) her über das Koppelelement Kij (in FIG 1 und FIG 2) die zum Eingang des Inverters J führende Matrix-Zeilenleitung zi auf das dem damit durchgeschalteten Bit entsprechende Potential umgeladen. Da der Inverter J in der Umgebung seiner Schaltschwelle eine hohe Spannungsverstärkung aufweist, genügt schon eine kleine Umladung der Matrix-Zeilenleitung zi, um ggf. am Inverterausgang (Eingang D des D-Kippgliedes DK) einen eindeutigen Übergang des Digitalsignals von dem jeweils einen in den jeweils anderen Signalzustand zu bewirken, der dann am Ende der Hauptphase mit der Taktflanke vom D-Kippglied DK übernommen wird und damit am zugehörigen Ausgang ai der Koppeleinrichtung gegeben ist.

Je näher das Potential der Matrix-Zeilenleitung zi während der - als Auto-Zero-Phase zu bezeichnenden - Vorphase pv der Schaltschwelle des Inverters J kommen soll, desto niedriger müssen die Widerstände der beiden Inverter-Transistoren Tp, Tn sein. Den damit allerdings verbundenen Inverter-Querstrom und die daraus resultierende Verlustleistung kann man andererseits herabsetzen, wenn man den Inverter J mit höheren Widerstandswerten auslegt, wobei dann zu Beginn der Hauptphase ph (siehe FIG 5 unten) zwischen dem am Invertereingang zi erreichten Potential und der Inverter-Schaltschwelle eine Potentialdifferenz verbleibt, aufgrund derer die Leitungsumladung bis zum Überschreiten der Schaltschwelle noch weiterer Zeit bedarf. Bei der Schaltungsdimensionierung ist somit zwischen den Kriterien Verlustleistung und Schaltzeit zu optimieren.

Signalverläufe, wie sie sich in einer Ausgangsverstärkerschaltung Ai gemäß FIG 3 ergeben können, zeigt in prinzipieller Darstellung FIG 5. Dabei geht FIG 5 von einem in der Kurve sj dargestellten Signalverlauf auf der Matrix-Spaltenleitung sj (in FIG 1 und FIG 2) aus, dem eine Bitfolge -1-0- zugrundeliegen mag, wobei gestrichelt und punktiert von der Betriebsweise des Eingangstreibers abhängige Varianten im Signalverlauf angedeutet sind. Mit der Kurve zi in FIG 5 ist dann der am Invertereingang zi (in FIG 3) sich ergebende Potentialverlauf dargestellt, und mit der Kurve D in FIG 5 ist schließlich der in der Ausgangsverstärkerschaltung Ai gemäß FIG 3 am Ausgang des Inverters J und damit am Eingang D des nachfolgenden D-Kippgliedes DK verlauf dargestellt. Mit der in FIG 5 gestrichelt gezeichneten Kurve T wird die Schaltschwelle des Inverters J (in FIG 3) angedeutet.

Die gleichen prinzipiellen Spannungsverläufe, wie sie in FIG 5 skizziert sind, ergeben sich auch bei Ausbildung der Ausgangsverstärkerschaltung Ai in der aus FIG 4 ersichtlichen Weise. In der Ausgangsverstärkerschaltung Ai gemäß FIG 4, die hinsichtlich der Kettenschaltung von C-MOS-Inverter J und D-Kippglied DK und der Beschaltung der Steuerelektrode des Schalter-Transistors S mit der Schaltungsanordnung gemäß FIG 3 übereinstimmt, liegt der Schalter-Transistor S mit seiner einen Hauptelektrode wiederum am Invertereingang zi, mit seiner anderen Hauptelektrode nunmehr aber am Ausgang b eines Referenzspannungsgenerators B. Während der Vorphase pv (siehe FIG 5) wird dann die zum Eingang des Inverters J führende Matrix-Zeilenleitung zi über den leitenden Schalter-Transistor S auf das vom Referenzspannungsgenerator B abgegebene, der Schaltschwelle des Inverters J entsprechende Potential umgeladen. Da dieser Umladungsvorgang nunmehr nicht durch den Inverter J selbst bewirkt wird, kann letzterer auf hohe Widerstandswerte hin ausgelegt sein, ohne daß damit die Umladung beeinträchtigt wird. In der nachfolgenden Hauptphase ph (siehe FIG 5) wird dann in der gleichen Weise, wie dies oben bereits zu FIG 3 erläutert wurde, von der zugehörigen Spaltenleitung sj (in FIG 1 und FIG 2) her über das Koppelelement Kij (in FIG 1 und FIG 2) die zum Eingang des Inverters J führende Matrix-Zeilenleitung zi auf das dem damit durchgeschalteten Bit entsprechende Potential umgeladen.

Als Referenzspannungsgenerator B kann, wie dies auch aus FIG 4 ersichtlich ist, ein in gleicher Weise wie der Inverter J dimensionierter rückgekoppelter C-MOS-Inverter vorgesehen sein, der zur Erzielung eines niedrigen dynamischen Innenwiderstands durch einen Kondensator abgeblockt ist.

Ebenso kann in die vom rückgekoppelten Inverter zum Kondensator führende Verbindung auch ein gegengekoppelter (als Spannungsfolger geschalteter) Differenzverstärker eingefügt sein, was in FIG 4 jedoch nicht näher dargestellt ist. Wie in FIG 4 angedeutet ist, kann für eine Mehrzahl von Schalter-Transistoren S auch ein gemeinsamer Referenzspannungsgenerator B vorgesehen sein; ohne daß dies in FIG 4 noch näher dargestellt ist, können in einer Breitband-Koppeleinrichtung gemäß der Erfindung verteilt auch mehrere Referenzspannungsgeneratoren vorgesehen sein.

Abschließend sei noch folgendes bemerkt: In den in FIG 3 und FIG 4 skizzierten Ausführungsbeispielen ist in der Kettenschaltung von C-MOS-Inverter und Halteglied als Halteglied jeweils ein D-Kippglied (DK) vorgesehen. Die Erfindung ist indessen hierauf nicht beschränkt; das Halteglied kann vielmehr auch in anderer Weise realisiert sein, etwa durch einen Kondensator, der seinerseits auch mit der Eingangskapazität eines (weiteren) C-MOS-Inverters realisiert sein kann, und anstelle des (wenigstens einen) C-MOS-Inverters kann auch (wenigstens) ein anderes invertierendes C-MOS-Verknüpfungsglied vorgesehen sein.

**Patentansprüche**

1. Breitbandsignal-Koppeleinrichtung mit einer Koppelpunktmatrix in FET-Technik, an deren Eingängen (ej-sj) jeweils eine Eingangstreiberschaltung (Ej) vorgesehen sein kann und deren Ausgänge (zi-ai) jeweils mit einer Ausgangsverstärkerschaltung (Ai) versehen sind,
   **dadurch gekennzeichnet,**
   daß die Koppelpunkte (KPij) mit im Durchschaltezustand jeweils einen gegenüber dem an einem Matrixeingang (sj) wirksamen Innenwiderstand großen Durchlass- bzw. Innenwiderstand aufweisenden Koppelelementen (Kij) gebildet sind
   und daß die Ausgangsverstärkerschaltungen (Ai)
   jeweils eine in die betreffende Ausgangsleitung (zi-ai) eingefügte Kettenschaltung wenigstens eines invertierenden C-MOS-Verknüpfungsgliedes und eines Haltegliedes (DK) und einen mit seiner einen Hauptelektrode am Verknüpfungsglied-Eingang liegenden Schalter (S) mit gegenüber dem Widerstand eines Koppelelements (Kij) kleinem Durchlasswiderstand aufweisen,
   dessen Steuerelektrode mit einem eine Bit-Durchschaltezeitspanne in eine Vorphase (pv) und die eigentliche Durchschaltephase (ph) unterteilenden Koppelfeld-Durchschalte-Takt beaufschlagt ist
   und über den in jeder Vorphase (pv) die betreffende Ausgangsleitung (zi) der Koppelpunktmatrix zumindest angenähert auf das der Schaltschwelle des Verknüpfungsgliedes (J) entsprechende Potential umgeladen wird, um hiervon ausgehend in der nachfolgenden Durchschaltephase (ph) über das jeweilige Koppelelement (Kij) auf das dem damit jeweils durchgeschalteten Bit entsprechende Potential umgeladen zu werden.

2. Breitband-Koppeleinrichtung nach Anspruch 1,
   **dadurch gekennzeichnet,**
   daß das Verknüpfungsglied durch einen C-MOS-Inverter (J) gebildet ist.

**3.** Breitband-Koppeleinrichtung nach Anspruch 1 oder 2, **dadurch gekennzeichnet,** daß die andere Hauptelektrode des Schalters (S) am Ausgang des Verknüpfungsgliedes (J) liegt.

**4.** Breitband-Koppeleinrichtung nach Anspruch 1 oder 2, **dadurch gekennzeichnet,** daß die andere Hauptelektrode des Schalters (S) am Ausgang (b) eines Referenzspannungsgenerators (B) liegt.

**5.** Breitband-Koppeleinrichtung nach Anspruch 4, **dadurch gekennzeichnet,** daß ein (oder mehrere) jeweils einer Mehrzahl von Schaltern (S) gemeinsamer (gemeinsame) Referenzspannungsgenerator(en) (B) vorgesehen ist (sind).

**6.** Breitband-Koppeleinrichtung nach Anspruch 2 und nach Anspruch 4 oder 5, **dadurch gekennzeichnet,** daß der Referenzspannungsgenerator (B) mit einem in gleicher Weise wie der Inverter (J) einer Kettenschaltung dimensionierten, rückgekoppelten C-MOS-Inverter gebildet ist.

**7.** Breitband-Koppeleinrichtung nach einem der vorhergehenden Ansprüche, **dadurch gekennzeichnet,** daß das Halteglied durch ein an seinem Takteingang mit dem Koppelfeld-Durchschalte-Takt beaufschlagtes D-Kippglied (DK) gebildet ist.

## Claims

**1.** Switching device for broadband signals comprising a switching-point matrix in FET technology, at the inputs (ej-sj) of which in each case an input driver circuit (Ej) can be provided and the outputs (zi-ai) of which are in each case provided with an output amplifier circuit (Ai), characterised in that the switching points (KPij) are formed by means of switching elements (Kij) which in each case have a large on-state or internal resistance in the switching through state compared with the internal resistance effective at a matrix input (sj), and in that the output amplifier circuits (Ai) have in each case a cascade circuit, inserted into the output line (zi-ai) concerned, of at least one inverting CMOS logic element and of a latch (DK), and a switch (S), which is located at the logic element input with its one main electrode and has a small on-state resistance compared with the resistance of a switching element (Kij), to the control electrode of which switch a switching matrix switching-through clock subdividing a bit switching-through period into a preliminary phase (pv) and the actual switching-through phase (ph) is applied and via which the respective output line (zi) of the switching-point matrix is at least approximately recharged, in each preliminary phase (pv) to the potential corresponding to the switching threshold of the logic element (J) in order to be recharged, starting from this potential, in the subsequent switching-through phase (ph), to the potential corresponding to the bit thus switched through in each case via the respective switching element (Kij).

**2.** Broadband switching device according to Claim 1, characterised in that the logic element is formed by a CMOS inverter (J).

**3.** Broadband switching device according to Claim 1 or 2, characterised in that the other main electrode of the switch (S) is connected to the output of the logic element (J).

**4.** Broadband switching device according to Claim 1 or 2, characterised in that the other main electrode of the switch (S) is connected to the output (b) of a reference voltage generator (B).

**5.** Broadband switching device according to Claim 4, characterised in that one (or several) reference voltage generator(s) (B) in each case common to a plurality of switches (S) is (are) provided.

**6.** Broadband switching device according to Claim 2 and according to Claim 4 or 5, characterised in that the reference voltage generator (B) is formed by means of a feedback-type CMOS inverter dimensioned in the same manner as the inverter (J) of a cascade circuit.

**7.** Broadband switching device according to one of the preceding claims, characterised in that the latch is formed by a D-type flip flop (DK) to which the switching matrix switching-through clock is applied at its clock input.

## Revendications

**1.** Dispositif de couplage pour signaux à large bande comportant une matrice de points de couplage réalisée selon la technique FET et aux entrées (ej-sj) desquelles peut être prévu respectivement un circuit formant étage d'attaque d'entrée (Ej) et dont les sorties (zi-ai) sont pourvues respectivement d'un circuit amplificateur de sortie (Ai),

caractérisé par le fait

que les points de couplage (KPij) sont formés par des éléments de couplage (Kij) qui possèdent, à l'état interconnecté, respectivement une résistance à l'état passant ou résistance interne élevée par rapport à la résistance interne agissant à une entrée (sj) de la matrice, et

que les circuits amplificateurs de sortie (Ai) possèdent respectivement un circuit itératif, inséré dans la ligne de sortie considérée (zi-ai), d'au moins un circuit combinatoire (C-MOS) inverseur et d'un circuit de maintien (DK), et un interrupteur (S), qui est raccordé par son électrode principale à l'entrée du circuit combinatoire et possède une résistance à l'état passant faible par rapport à la résistance d'un élément de couplage (Kij), et

dont l'électrode de commande est chargée par une cadence d'interconnexion du champ de couplage, qui subdivise un intervalle de transmission directe des bits en une phase préalable (pv) et en la phase proprement dite de transmission (ph), et

par l'intermédiaire duquel, pendant chaque phase amont (pv), la ligne de sortie considérée (zi) de la matrice de points de couplage est déchargée au moins approximativement au potentiel correspondant au seuil de commutation du circuit combinatoire (J), pour être rechargée, à partir de là, pendant la phase suivante de transmission (ph), par l'intermédiaire de l'élément de couplage (Kij) respectif, au potentiel correspondant aux bits transmis respectivement par cet élément de couplage.

2. Dispositif de couplage à large bande suivant la revendication 1, caractérisé par le fait que le circuit combinatoire est formé par un inverseur C-MOS (J).

3. Dispositif de couplage à large bande suivant la revendication 1 ou 2, caractérisé par le fait que l'autre électrode principale de l'interrupteur (S) est raccordée à la sortie du circuit combinatoire (J).

4. Dispositif de couplage à large bande suivant la revendication 1 ou 2, caractérisé par le fait que l'autre électrode principale de l'interrupteur (S) est raccordée à la sortie (b) d'un générateur de tension de référence (B).

5. Dispositif de couplage à large bande suivant la revendication 4, caractérisé par le fait qu'il est prévu un (ou plusieurs) générateur(s) de tension de référence (B) commun(s) respectivement à une multiplicité d'interrupteurs (S).

6. Dispositif de couplage à large bande suivant la revendication 2 et les revendications 4 ou 5, caractérisé par le fait que le générateur de tension de référence (B) est formé par un inverseur C-MOS comportant une branche de réaction et dimensionné de la même manière que l'inverseur (J) d'un circuit itératif.

7. Dispositif de couplage à large bande suivant l'une des revendications précédentes, caractérisé par le fait que le circuit de maintien est formé par un circuit à bascule D (DK) dont l'entrée de cadence est chargée par la cadence d'interconnexion du champ de couplage.

# FIG 1

## FIG 2

## FIG 5

## FIG 3

## FIG 4